(19)

Europäisches
Patentamt
European
Patent Office
Office européen
des brevets

(11) **EP 2 302 712 A1**

(12) **EUROPEAN PATENT APPLICATION**

(43) Date of publication:
    **30.03.2011 Bulletin 2011/13**

(51) Int Cl.:
    ***H01L 41/113*** (2006.01)     ***H03H 9/02*** (2006.01)
    ***B81B 3/00*** (2006.01)

(21) Application number: **09171473.3**

(22) Date of filing: **28.09.2009**

(84) Designated Contracting States:
    **AT BE BG CH CY CZ DE DK EE ES FI FR GB GR
    HR HU IE IS IT LI LT LU LV MC MK MT NL NO PL
    PT RO SE SI SK SM TR**
    Designated Extension States:
    **AL BA RS**

(71) Applicant: **Stichting IMEC Nederland
    5656 AE Eindhoven (NL)**

(72) Inventors:
    • **Hohlfeld, Dennis
      5503 HA, Veldhoven (NL)**
    • **Van Schaijk, Rob
      5611 SG, Eindhoven (NL)**

(74) Representative: **Hertoghe, Kris Angèle Louisa et al
    DenK iP bvba
    Hundelgemsesteenweg 1114
    9820 Merelbeke (BE)**

(54) **Method for resonance frequency tuning of micromachined structures**

(57)     A microstructure according to embodiments of the present invention comprises a substrate (11), and a resonant structure (12,15) having a resonance frequency and comprising a seismic mass (12) and suspension elements for suspending the seismic mass at two opposite sides onto the substrate. The substrate is adapted for functioning as a tuning actuator adapted for applying stress onto the suspension elements, thus changing the stiffness of the suspension elements. This way, the resonance frequency of the microstructure may be adapted to input vibration frequencies which may vary over time or may initially be unknown. By adapting the resonance frequency of the resonant structure, a suitable power may be generated, even in circumstances of variable input frequencies.

FIG. 1(a)

**Description**

**Field of the invention**

This invention relates to methods for tuning a resonance frequency of resonant structures, such as for example energy harvesters or sensors. Furthermore it relates to devices, e.g. micromachined devices, with tunable resonance frequency.

**Background of the invention**

Future wireless sensor networks will comprise sensor nodes which occupy a volume of typically a few cm$^3$. The scaling down of batteries for powering these sensor nodes faces technological restrictions as well as a loss in storage density. For this reason a worldwide effort is ongoing to replace batteries with more efficient, miniaturized power sources. Energy harvesters based on the recuperation of wasted ambient energy are a possible alternative to batteries. Several harvesting concepts have been proposed, based on the conversion of thermal energy, pressure energy or kinetic energy.

Kinetic energy harvesters or vibration energy harvesters convert energy in the form of mechanical movement (e.g. in the form of vibrations or random displacements) into electrical energy. For conversion of kinetic energy into electrical energy, different conversion mechanisms may be employed, for example based on piezoelectric, electrostatic or electromagnetic mechanisms. Piezoelectric harvesters employ active materials that generate a charge when mechanically stressed. Electrostatic harvesters utilize the relative movement between electrically isolated charged capacitor plates to generate electrical power. Electromagnetic harvesters are based on Faraday's law of electromagnetic induction and generate electrical power from the relative motion between a magnetic flux gradient and a conductor.

A vibration energy harvester has its maximum power output when input vibrations closely match its resonance frequency, which is determined by the material properties and the dimensions of the harvester's parts. However, in practical applications, input vibrations may occur in a wide frequency spectrum. The input vibration frequencies may vary over time or may initially be unknown. In such situations the vibration energy harvester structure may stay out of resonance, and generate very low power or no power at all. It would be clearly advantageous to have a single device that operates effectively over a range of input vibration frequencies. This may be obtained by developing resonators with wider bandwidths or by providing actuators to tune the harvester's resonance frequency.

There are a limited number of studies related to tuning the resonance frequency of vibration energy harvesters. For example, in "Resonance tuning of piezoelectric vibration energy scavenging generators using compressive axial preload", Smart Materials and Structures 15, 2006, 1413-1420, Leland et al describe a method wherein axial forces are applied on the suspension of a macroscopic double-clamped beam for changing the effective stiffness of the oscillating structure. In this approach, a simply supported piezoelectric bimorph is used as an active element, with a proof mass mounted at the bimorph's center. A compressive axial preload is applied to the bimorph, reducing its stiffness and thus the resonance frequency of the device. The stiffness decrease is a function of the load applied in a given system. However, the change in the apparent stiffness is inversely proportional to the initial stiffness. This means that the largest tuning effect can be achieved by starting with a low stiffness. Besides the relatively low stiffness requirement, the maximum axial load applied to the structure is determined by the buckling load, which is lower in a low stiffness system. In addition, it may be difficult to fabricate the system proposed by means of micromachining methods. The system obtained is operated 'passively', which means that it could be adjusted periodically to tune its resonance frequency but would require no continuous actuation.

In V.R. Challa et al, "A vibration energy harvesting device with bidirectional resonance frequency tunability", Smart Materials and Structures 17, p. 015035, 2008 a magnetic force is used to alter the overall stiffness and thus the resonance frequency of an energy harvesting device. Resonance frequency tuning is based on adjusting the position of permanent magnets. The position of the magnets is controlled externally. Resonance frequency tuning of a MEMS resonator using this approach may be unfeasible.

Resonance frequency tuning of oscillating structures is used in various MEMS resonators. More in particular, for resonators based on a comb structure (comprising interdigitated fingers) methods for post-fabrication resonance frequency tuning have been proposed. For example, in "A closed-form approach for frequency tunable comb resonators with curved finger contour", Sensors and Actuators A 141, p 523-529, 2008, K.B. Lee et al describe frequency tunable resonators with curved finger contours. However, fabricating the ideal design is not easy and it may require a lot of space.

In "Vertically-shaped tunable MEMS resonators", Journal of Microelectromechanical Systems, Vol. 17, No 1, p. 85, 2008, B. Morgan et al describe a tunable MEMS resonator with vertically-shaped comb fingers. However, for fabricating such structures gray scale lithography is needed.

In "A frequency selective silicon vibration sensor with direct electrostatic stiffness modulation", Analog integrated Circuits and Signal Processing, 37, pp 35-43, 2003, D. Scheibner et al describe a vibration sensor based on a MEMS comb resonator wherein electrostatic resonance tuning is implemented by means of a tuning actuator comprising a comb system with a linearly varying finger length. The tuning actuator and the resonator are co-fabricated. The electrostatic tuning mechanism proposed by Scheibner can only be used for energy harvesters with in-plane motion of the seismic mass, i.e. wherein the seismic mass moves in a plane parallel to the plane of the combs.

## Summary of the invention

It is an object of the present invention to provide a method for electrically tuning a resonance frequency of a resonant structure, e.g. MEMS or NEMS resonant structure. The method of the present invention can for example be used for tuning a resonance frequency of a vibration energy harvester or a sensor. It is an advantage of the tuning method of the present invention that it can be used for tuning a resonance frequency of different types of resonant structures, e.g. resonant structures with in-plane motion of a seismic mass as well as resonant structures with out-of-plane motion of a seismic mass.

It is a further object of the present invention to provide devices, e.g. micromachined devices, with electrically tuneable resonance frequency. It is an advantage of devices of the present invention that they can be compact and that they can easily be fabricated with standard micromachining techniques. Furthermore, the power consumption for tuning can be low. It is another advantage that the resonant structure and the tuning actuator can be fabricated separately. This allows optimizing the fabrication process and the properties of both the resonator structure and the tuning actuator independently.

The above objects are achieved by a method and a device according to embodiments of the present invention.

In a first aspect, the present invention provides a microstructure comprising a substrate, a resonant structure having a resonance frequency, and comprising a seismic mass and suspension elements for suspending the seismic mass at two opposite sides onto the substrate. According to the present invention, the substrate is adapted for functioning as a tuning actuator, preferably a linear tuning actuator, adapted for applying stress onto the suspension elements, thus changing the stiffness of the suspension elements. It is an advantage of at least some microstructures according to embodiments of the present invention to provide a compact micromachined device for electrostatic conversion of kinetic energy into electrical energy, such as e.g. a micromachined energy harvester, which can easily be brought into an adapted resonance frequency, chosen depending on the input vibration frequencies which may vary over time or may initially be unknown. By adapting the resonance frequency of the resonant structure, a suitable power may be generated, even in circumstances of variable input frequencies. It is furthermore an advantage of embodiments of the present invention that the resonance frequency can be tuned continuously, e.g. also during actual use of the microstructure as energy harvester or sensor, and not only during design, manufacturing or calibration phases.

According to embodiments of the present invention, the substrate may be made from piezoelectric material forming the tuning actuator. Piezoelectric actuation can cause a precise frequency shift of the resonant structure.

In particular embodiments, the substrate may comprise piezoelectric bulk material with in-plane extension. Hereto, the substrate may have a top and a bottom major surface, and the microstructure may furthermore comprise a first electrode at the top major surface and a second electrode at the bottom major surface of the substrate for actuating the piezoelectric material.

In alternative embodiments, the substrate may comprise two piezoelectric shear actuators. In such embodiments, the microstructure may furthermore comprise interdigitated electrodes for actuating the piezoelectric material. Such interdigitated electrodes may be provided at a same major surface of the substrate, thus simplifying the manufacturing process.

In a microstructure according to embodiments of the present invention, the suspension elements may comprise a straight beam and an anchor point, the straight beam being attached between the seismic mass and the anchor point. It is an advantage of embodiments of the present invention that the suspension elements are straight beams, because if they would be bent (e.g. L- or U-shaped) the axial stress applied for tuning the resonant structure could relax by twisting the joints.

According to embodiments of the present invention, the anchor point is mechanically attached to the substrate. The anchor point transfers the movement of the substrate into a stress onto the beam which is part of the suspension element.

According to embodiments of the present invention, the resonant structure may be any of a MEMS (Micro-Electro-Mechanical Systems) or a NEMS (Nano-Electro-Mechanical Systems) structure. It may be manufactured for example by semiconductor processing.

In a microstructure according to embodiments of the present invention, the resonant structure may be a double clamped structure, i.e. a resonant structure clamped at two opposite sides.

In a second aspect, the present invention provides the use of a microstructure according to embodiments of the first aspect of the present invention in any of a vibration energy harvester or a wireless sensor network, where it replaces batteries.

In a third aspect, the present invention provides a method for tuning a resonance frequency of a resonant structure anchored to a substrate at two opposite sides by means of suspension elements. The method comprises applying a stress on the suspension elements by means of the substrate, thus changing the stiffness of the suspension elements. By changing the stiffness of the suspension elements, the resonance frequency of the resonant structure is changed and hence its possibilities to convert kinetic energy of input vibrations of different frequencies into electrical energy.

In a method according to embodiments of the present invention, applying a stress by means of the substrate may include actuating a piezoelectric substrate. Actuating a piezoelectric substrate may comprise shear actuation of the piezoelectric substrate, or alternatively it may comprise applying an electric field over a thickness of the piezoelectric substrate.

In yet another aspect, the present invention provides the use of a method according to embodiments of the third aspect, for tuning a resonance frequency of a vibration energy harvester or a sensor.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The invention, both as to organization and method of operation, together with features and advantages thereof, may best be understood by reference to the following detailed description when read with reference to the accompanying drawings.

**Brief description of the drawings**

FIG. 1(a) and FIG. 1(b) illustrate an embodiment of the present invention wherein a resonant structure or resonator is attached to a piezoelectric actuator fabricated from a piezoelectric bulk material with in-plane extension. Fig. 1 (a) shows a top view and Fig. 1(b) shows a cross section along line A-A'.

FIG. 2 illustrates a top view of an embodiment of the present invention wherein a resonant structure or resonator is attached to two piezoelectric shear actuators featuring interdigitated electrodes.

FIG. 3 illustrates an embodiment of the present invention where the resonant structure is provided with only two suspension elements in the longitudinal direction of the resonant structure.

FIG. 4 shows a stray field electrode configuration for shear actuation of piezoelectric shear actuators, e.g. PZT-5A actuators.

FIG. 5(a) and FIG. 5(b) show cross-sections of the device of FIG. 2 along line V-V', in non-actuated and actuated state, respectively.

The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Any reference signs in the claims shall not be construed as limiting the scope.

In the different drawings, the same reference signs refer to the same or analogous elements.

**Detailed description of the invention**

The present invention will be described with respect to particular embodiments and with reference to certain drawings but the invention is not limited thereto but only by the claims.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Furthermore, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In the context of the present invention, the term 'tuning' is used to indicate an electrically controlled non-permanent (reversible) modification of a device property after fabrication of the device. In particular, in embodiments of the present invention, the resonance frequency of a resonant structure is tuned.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In one aspect, the present invention provides a method for electrically tuning a resonance frequency of a resonant structure, e.g. MEMS (Micro-Electro-Mechanical System) or NEMS (Nano-Electro-Mechanical System) resonant structure. The method of the present invention can for example be used for tuning a resonance frequency of a vibration energy harvester or a sensor.

The method of the present invention can be used for electrically tuning a resonance frequency of double-clamped resonant structures, i.e. resonant structures that are clamped or fixed at two opposite sides. For example, the resonant structure may comprise a double-clamped beam (also called a bridge) or a plurality of double-clamped beams. In such case, the beam(s) is (are) clamped in longitudinal direction, for example by means of a suspension element at each extremity in longitudinal direction of the bridge. The resonance frequency of a mechanical structure in general is derived from its geometry and material parameters. If the structure comprises multiple beams, each beam may have its own distinct resonance frequency, and the resonance frequency of the complete structure is a function of the distinct resonance frequencies of the beams. In alternative embodiments, the movable structure is not just a bridge, but has a brick-shape, e.g. a rectangular shape with a pre-determined volume, for example a rectangular shape having a width and length of comparable size. In such case it is preferred to have at least four suspension elements, e.g. two suspension elements at each of two opposite sides. It is preferred that suspension elements opposite to each other have the same longitudinal axis. It is the in-line stress, i.e. the stress along the longitudinal axis of the suspension elements that determines the change in stiffness of the suspension elements and thus the change in resonance frequency of the resonant structure. Stress in other directions has a negligible effect. In embodiments of the present invention, the suspension elements can be made from semiconductor material, e.g. from silicon. Silicon can be strained by 0.5% of its length. This is sufficient for tuning.

In embodiments of the present invention, the resonant structure may comprise a seismic mass that is clamped by at least two suspension elements at two opposite sides of the mass, wherein both suspension elements are fixed to a substrate. It is an advantage of embodiments of the present invention that the suspension elements are straight elements, because if they would be bent (e.g. L- or U-shaped) the axial stress applied for tuning the resonant structure could relax by twisting the joints. In general, a tuning method according to embodiments of the present invention can be used for configurations where the restoring force, i.e. the force arising from the mechanical stiffness of the suspension, or worded differently the ratio between exciting force and resulting displacement, is generated by a mechanical suspension.

In a configuration with a double-clamped resonant structure in accordance with embodiments of the present invention, providing an axial force (tensile or compressive) on the suspension elements or clamps leads to a change in the effective stiffness of the suspension. It is known that the resonance frequency of a spring suspended mass is defined through the inertia of the seismic mass and the stiffness of the suspension.

In embodiments of the present invention a piezoelectric tuning actuator is used for adapting the stiffness of the suspension of a resonant structure, thereby adapting or tuning the resonance frequency of the resonant structure. The resonant structure is physically attached to a substrate by means of the suspension elements. A method according to embodiments of the present invention comprises applying a force (tensile or compressive) on the suspension elements by means of the substrate, thus changing the stiffness of the suspension elements, hence tuning the resonance frequency of the resonant structure.

In embodiments of the present invention, the substrate adapted for applying a force on the suspension elements may be a piezoelectric substrate. In the presence of an electrical field the dimensions of the piezoelectric substrate change, which generates stress in the suspension elements attached thereto. Piezoelectricity is the ability of some materials, notably crystals and certain ceramics, to generate an electric potential in response to applied mechanical stress. The piezoelectric effect is reversible in that materials exhibiting the direct piezoelectric effect (the generation of an electrical field, resp. electrical charge, when stress is applied) also exhibit the reverse piezoelectric effect (the production of stress and/or strain when an electric field is applied). It is this reverse piezoelectric effect which may be used in accordance with embodiments of the present invention. For example, lead zirconate titanate crystals will exhibit a maximum shape change of about 0.1% of the original dimension.

In embodiments of the present invention, the effective mechanical stiffness of the double-clamped resonant structure, which is the superposition of the stiffness of the unstressed suspension elements and the stiffness change induced by stretching the suspension elements, is thus electrically controlled by a voltage source which biases the piezoelectric actuator.

It is an advantage of using a piezoelectric substrate as a tuning actuator that the resonant structure and the tuning actuator can be fabricated separately, allowing optimization of the fabrication process for both the resonant structure and the tuning actuator. Piezoelectric bulk material is available in a variety of shapes, e.g. flat squares or disks, with lateral sizes up to 6 cm. This material can for example be based on lead zirconate titanate (PZT) with modifications to the stochiometry, e.g. to optimize piezoelectric properties, temperature stability or mechanical stiffness. It is an advantage of using a piezoelectric substrate, that material with well-defined and stable properties is used. Furthermore, piezoelectric material can be integrated in the processing of MEMS or NEMS devices.

It is another advantage of a method according to embodiments of the present invention that the power consumption for tuning can be very low. Piezoelectric static actuation requires a DC voltage, and due to the capacitance characteristic of the actuator (the actuator comprises two electrodes with piezoelectric material in between) only very low power levels are needed, e.g. 1 $\mu$W or lower. Such a piezoelectric capacitor is biased with a DC voltage, and thus the steady-state power consumption is determined by the parasitic (leakage) resistance of the capacitor. The intrinsic resistivity of piezoelectric materials is very high (e.g. higher than $10^{12}$ Ohm cm), which leads to a very low leakage current. Only parasitic shunt resistances might give rise to power consumption.

It is another advantage of a method according to embodiments of the present invention that the resonance frequency can be tuned continuously. This allows adapting at any time the resonance frequency to input vibration frequencies which may vary over time.

In another aspect, the present invention provides a microstructure comprising a substrate, a resonant structure having a resonance frequency, and suspension elements for suspending the resonant structure at two opposite sides onto the substrate. According to embodiments of the present invention, the substrate is adapted for functioning as a tuning actuator adapted for applying stress onto the suspension elements, thus changing the stiffness of the suspension elements and hence changing the resonance frequency of the resonant structure. In particular embodiments, the substrate is made from piezoelectric material. Both piezoelectric material with in-plane extension and the more efficient shear actuation of a piezoelectric substrate may be used.

In use, a double-clamped resonant structure according to embodiments of the present invention will be excited by a vibration of certain frequency and displacement amplitude. This driving frequency makes the resonant structure move with a different amplitude at the same frequency , and this movement generates an output power by converting the mechanical energy from vibrations into usable electrical energy. As stated above, the conversion may be performed either by the resonator integrating piezoelectric material on the deformed sections of the suspensions elements, in which case the stress in the deformed area generates electrical field/charge, or by the resonator integrating a biased variable capacitor, in which case electrical power can be obtained from the capacitance variation. If the resonance frequency of the double-clamped resonant structure is tuned so as to be equal to or closely matching the driving frequency, then the output power is maximal. Preferably the frequency mismatch should be less than a few percent, e.g. less than 3%, less than 2%, less than 1%. A frequency mismatch of only a few percent already results in a significant decrease in output power.

The present invention further provides devices, e.g. micromachined devices, comprising a resonant structure (e.g. sensor, energy harvester) and a tuning actuator for electrically tuning a resonance frequency of the resonant structure. The resonant structure and the tuning actuator may be fabricated separately. Their fabrication may be integrated in one process flow.

In the further description, the frequency tuning method and device according to embodiments of the present invention are illustrated for double-clamped energy harvesters. However, the method of the present invention can also be used for tuning a resonance frequency of other devices, such as for example resonators used in resonant sensors (e.g. accelerometers, pressure sensors, mass sensors, ...) or in oscillators.

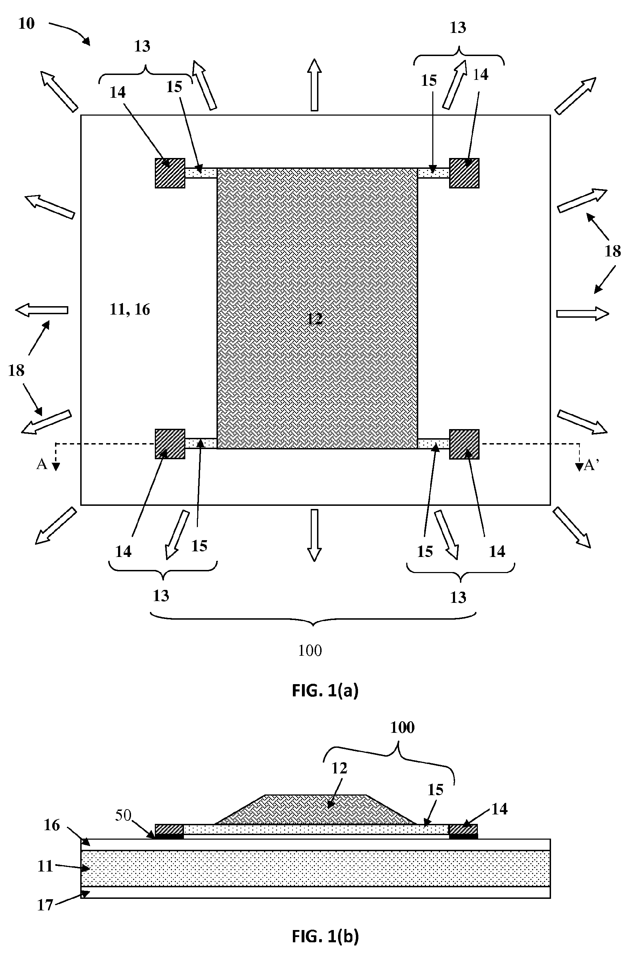

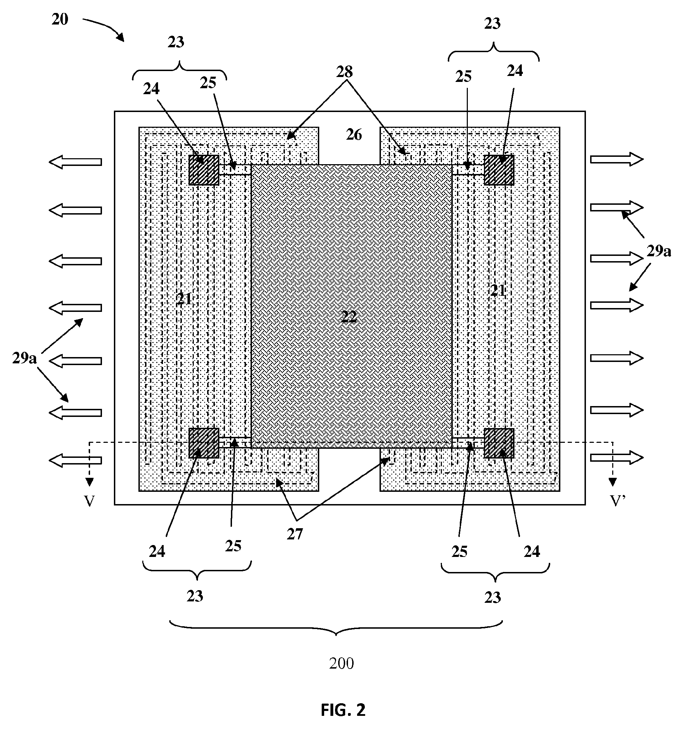

Two embodiments of a method and device for resonance frequency tuning of a resonant device or structure according to the present invention are illustrated in FIG. 1(a) and FIG. 1(b), and FIG. 2, respectively.

FIG. 1(a) shows a top view and Fig. 1(b) shows a cross section of a microstructure in the form of a vibration energy harvester 10, comprising a piezoelectric substrate 11 and a resonant structure 100 comprising a mass 12 physically attached to the piezoelectric substrate 11 by means of suspension elements 13, wherein the piezoelectric substrate 11 can be used as an actuator for tuning the resonance frequency of the resonant structure 100. FIG. 1(a) and FIG. 1 (b) show an embodiment with longitudinal piezoelectric actuation, i.e. an embodiment wherein the actuator is fabricated from piezoelectric bulk material with in-plane extension. Such a piezoelectric substrate 11 is also called a piezoelectric disc. When applying a voltage over this substrate 11, it is not bending but it is stretching in all directions. If the substrate would be a circular substrate, it would remain circular but with a larger diameter. In case of a rectangular substrate the sides become a little bit rounded, but this effect is very small. Stretching of the substrate 11 leads to an outwards movement of the four anchor points 14 of the suspension elements 13 of the suspended structure. The forces inside the piezoelectric substrate are the same in all directions, as illustrated by arrows 18.

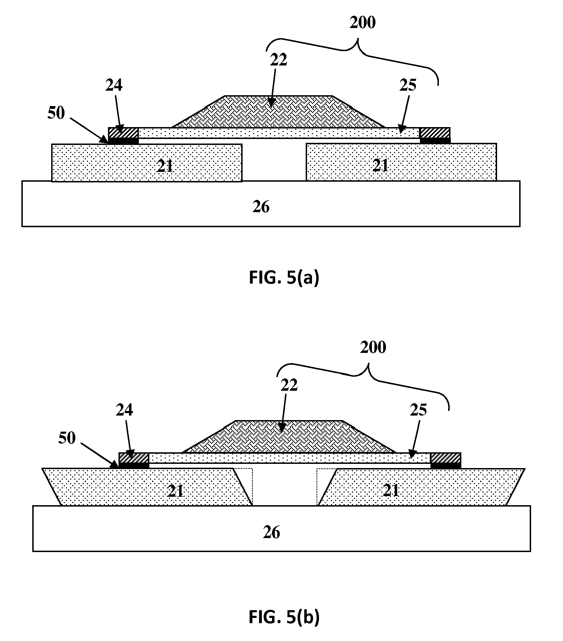

FIG. 2 shows a top view of a microstructure according to an embodiment of the present invention, in the form of a vibration energy harvester 20, comprising a piezoelectric substrate under the form of two piezoelectric shear actuators 21 and a resonant structure 200 comprising a mass 22 physically attached to the piezoelectric substrate 21 by means of suspension elements 23, wherein the piezoelectric substrate 21 can be used as an actuator for tuning the resonance frequency of the resonant structure 200. FIG. 5(a) and FIG. 5(b) show cross sections of this microstructure along line V-V', in non-actuated state (FIG. 5(a)) and in actuated state (FIG. 5(b)). Contrary to the embodiment illustrated in FIG. 1(a) and FIG.1(b), the embodiment of FIG.2 works in shearing mode. In this embodiment, the piezoelectric crystal is cut in a different way as compared to the embodiment of FIG. 1(a) and FIG. 1(b). The behavior of a piezoelectric bulk material depends on the orientation of the crystals inside this structure. By using a different cut direction when cutting the material, a different behavior is obtained. Piezoelectric materials with different crystal directions are commercially available.

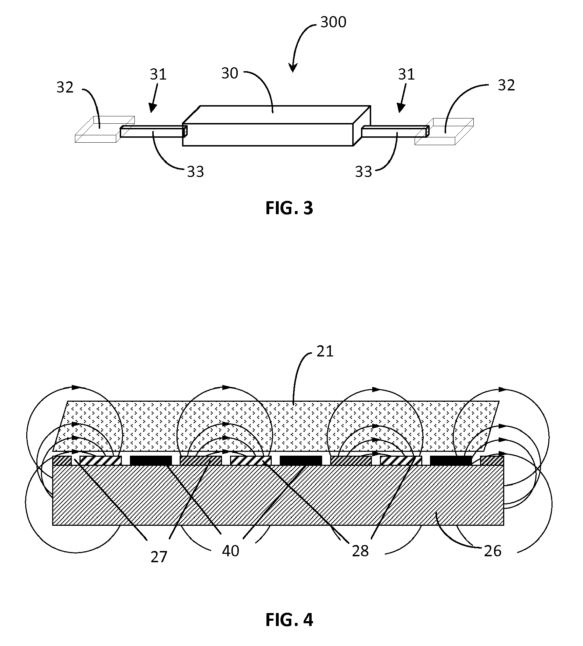

In embodiments of the present invention the resonant structure 100, 200 is physically attached to the substrate 11, 21 by means of suspension elements 13, 23 at at least two anchor points 14, 24, for example at four anchor points. The number of anchor points actually used depends on the dimensions of the resonant structure 100, 200. An example of a resonant structure 300 comprising a mass 30 and only two suspension elements 31 and two anchor points 32 is illustrated in FIG. 3. The suspension elements 31 are provided in the longitudinal direction of the resonant structure 300. For the devices as shown in FIG. 1 and FIG. 2, it is preferred that the resonant structure 100, 200 (including or consisting of a seismic mass 12, 22) is attached to four anchor points 14, 24, as this allows preventing rotational motion of the resonant structure 100, 200. The suspension elements 13, 23 are physically connected at one end to the anchor point 14, 24 on the substrate 11, 21 and at the other end to the seismic mass 12, 22. As illustrated, the suspension elements 13, 23, 31 comprise straight beams 15, 25, 33 with a pre-determined height, width and length. According to embodiments of the present invention, the seismic mass 12, 22, 30, the beams 15, 25, 33 of the suspension elements 13, 23, 31 and optionally the anchor points 14, 24, 32 may be fabricated from a same layer of material, for example semiconductor material such as silicon or silicon germanium. Therefore there is a continuous volume of material along this arrangement. At the anchor point 14, 24, 32 the suspension beam 15, 25, 33 widens to form an anchor pad - such anchor point 14, 24, 32 is connected to a suspension beam 15, 25, 33 which is called its related suspension beam. The pad's top or bottom side is mechanically connected to the substrate 11, 21, for example by means of bonding or by means of e.g. glue 50.

In the embodiment illustrated in FIG. 1(a) and FIG. 1(b), the mass 12 of the resonant structure 100 is attached at four anchor points 14 to a single piezoelectric substrate 11, acting as a tuning actuator. The mass 12, in the embodiment illustrated, is a rectangular structure in top view, having two opposite major sides. Two anchor points 14 and corresponding suspension beams 15 are provided at one major side of the rectangular structure and perpendicular thereto in the plane of the substrate, and two other anchor points and corresponding suspension beams are provided at the other major side of the rectangular structure and perpendicular thereto in the plane of the substrate. In embodiments of the present invention, the suspension beams are provided at the extremities of the major sides, or close thereto. By providing the suspension beams at the extremities of the major sides or close thereto, the displacement of the mass 12 is limited to one direction. Also rotations are restricted if the connections to the suspension beams are done at the outermost corners of the mass. In the example shown, the tuning actuator, substrate 11, is fabricated from piezoelectric bulk material with in-plane extension, i.e. a material that changes its lateral dimensions (i.e. in a plane parallel to the substrate surface) in the presence of a vertical electrical field (i.e. an electrical field that is substantially orthogonal to the substrate surface). In this embodiment, an electric field is applied parallel to the polarization direction of the piezoelectric material. The actuators' top and bottom surface are covered with a top electrode 16 and a bottom electrode 17, respectively; for example electrodes made from platinum, aluminum, silver. Tuning the resonance frequency of the resonant structure 100 comprises applying a DC voltage between these electrodes 16, 17 so that a suitable electrical field is obtained over the piezoelectric substrate 11 so as to deform the substrate 11 under the piezoelectric effect. Such a suitable electrical field strength may be for example 10 kV/m, which, as an example only, corresponds to a voltage of 10 V over a substrate thickness of 1 mm. It is an advantage of the embodiment illustrated in FIG. 1(a) and FIG. 1(b) that it has a better power efficiency as compared to other actuation mechanisms which use current-based schemes.

In an alternative embodiment, illustrated in FIG. 2, the seismic mass 22 is attached at four anchor points 24 to a substrate comprising two piezoelectric shear actuators 21. In this embodiment, contrary to the embodiment illustrated in FIG. 1(a) and FIG. 1(b), an electric field is applied perpendicular to the polarization direction of the piezoelectric material. In the illustration of FIG. 2, the two piezoelectric shear actuators 21 are provided on a further bottom substrate 26 which is not necessarily piezoelectrically active. The seismic mass 22, in the embodiment illustrated, is a rectangular structure in top view, having two opposite major sides. Two anchor points 24 and corresponding suspension beams 25 are provided at one major side of the rectangular structure and perpendicular thereto in the plane of the substrate 21, and two other anchor points 24 and corresponding suspension beams 25 are provided at the other major side of the rectangular structure and perpendicular thereto in the plane of the substrate 21. In embodiments of the present invention, the suspension beams 25 are provided at the extremities of the major sides, or close thereto. By providing the suspension beams at the extremities of the major sides or close thereto, the displacement of the mass 22 is limited to one direction. Also rotations are restricted if the connections to the suspension beams are done at the outermost corners of the mass. The shear actuators 21 are located at two opposite sides of the seismic mass 22, each underneath the anchor points 24 provided at one major side of the rectangular structure forming the seismic mass 22.

In the presence of an electric field a shear moment is induced in the piezoelectric material 21. In order to obtain this, electrodes 27, 28 are provided. In FIG. 2 the electrodes 27, 28 are shown as dotted lines because in the example shown the electrodes 27, 28 are provided in between the substrate and the piezoelectric shear actuators 21. It is an advantage of the embodiment illustrated in FIG. 2 that the electrodes 27, 28 may be provided in a plane, both at one side of the piezoelectric material 21, such that double-side processing of the piezoelectric substrate material 21 can be avoided. Biasing the piezoelectric material 21 leads to a shear deformation thereof (as illustrated in FIG. 5(b)), hence to a lateral displacement of the piezoelectric material surface onto which the resonant structure 200 is attached. This lateral deformation is indicated in FIG. 2 by arrows 29a. This deformation of the piezoelectric material 21, if in opposing directions for each of the piezoelectric shear actuators, as illustrated in FIG. 2, applies forces to the anchor points 24; the forces are indicated by the arrows 29b. These forces indicated by arrows 29b strain the suspension elements 23. Actuating the piezoelectric material 21 thus leads to a tensile stress in the double-clamped suspension.

The piezoelectric actuators 21 in the embodiment shown in FIG. 2 cannot be sheared with an electrical field perpendicular to its plane. Therefore, the stray field of interdigitated electrodes 27, 28 below the actuator 21 as shown in FIG. 2 or in more detail in FIG. 4 may be used.

Actuation of the interdigitated electrodes 27, 28 generates a net electrical field which is in the plane of the shear actuator. The use of the stray field also simplifies the electrode scheme. Here, two electrodes 27, 28, e.g. interdigitated electrodes having electrode fingers, can be arranged on one side of the piezoelectric crystal 21 only, so there is no need to contact two opposite sides of the piezoelectric crystal 21. In the embodiment illustrated in FIG.4, grounded lines 40 are provided in between each pair of electrode fingers. These grounded lines 40 function as shield electrodes, preventing the field lines to stretch to neighboring actuation electrodes.

FIG. 5(b), when compared to FIG.5(a) illustrates the effect of actuating the piezoelectric substrate 21 by means of applying an actuation signal to the electrodes 27, 28 (not illustrated in FIG. 5(a) or FIG. 5(b)). The resonant structure 200 is connected by means of the suspension elements 23 to the piezoelectric substrate 21, e.g. by means of anchor pads 24 which are mechanically attached to the piezoelectric substrate 21, for example by means of glue 50 or another bonding mechanism. The deformation of the piezoelectric substrate 21 when actuated is illustrated in FIG. 5(b). This deformation of the piezoelectric substrate 21 leads to stress on the suspension elements 23, hence to a change of the resonance frequency of the resonant structure 200.

In embodiments of the present invention stiffening of a suspension element 13, 23, 31 is used for frequency tuning. The stiffening effect causes the spring constant of a suspension element or flexure to increase under application of an applied tensile stress. The restoring force as a function of the mass deflection x and the total normal force $F_N$ is given by:

$$F_x(x, F_N) = \left(k_0 + \frac{12}{5}\frac{F_N}{l}\right)x \text{ with } k_0 = 12\frac{EI}{l^3} \text{ and } I = \frac{hw^3}{12}. \tag{1}$$

Here, $k_0$ is the spring constant of the non-tuned system, E is the Young's modulus, $I$ the moment of inertia and $l$ the length of the (double-clamped) flexure.

The tuned resonance frequency is then given by

$$f_{res} = \frac{1}{2\pi}\sqrt{\frac{k_t}{m}} \text{ with } k_t = k_0 + \frac{12}{5}\frac{F_N}{l}. \tag{2}$$

In order to verify the feasibility of the tuning approach according to embodiments of the present invention, the stiffness term (induced by tensile stress) can be compared with the mechanical spring constant $k_0$. This gives:

$$\frac{k_t}{k_0} = 1 + \frac{12}{5}\frac{\Delta l\ l}{w^2} \text{ with } F_N = wh\sigma \text{ and } \sigma = \frac{\Delta l}{l}E. \tag{3}$$

This can be illustrated for an example wherein the following assumptions are made:

- desired resonance frequency, $f_{res} \approx 300$ Hz,
- seismic mass, m = 20 mg (density, p= 2330 kg m$^{-3}$, dimensions 3 x 6 x 0.5 mm$^3$),
- width of suspension element, $w$ = 10 $\mu$m
- height of suspension element, h = 100 $\mu$m
- required length of suspension element, $l$ = 1 mm (four suspension elements in total)

In order to achieve a shift in resonance frequency of 5 % in this case, a change in stiffness of 10.3 % is needed. Therefore a change in suspension element length of approximately 4.3 nm is needed to induce the required strain. The tensile stress ($\sigma$ = 0.73 MPa) is still far below the fracture strength of silicon ($\sigma_{crit}$ = 30 GPa).

Next a block of piezoelectric material, e.g. lead zirconate titanate (PZT-5A), is considered. Its piezoelectricity is described mathematically within the material's constitutive equation, which defines how the piezoelectric material's stress ($T$), strain ($S$) and electric field ($E$) interact.

$$S = s_E \underline{T} + d^T \vec{E} \tag{4}$$

Here, only strain induced by the presence of an electrical field is considered. The piezoelectric coupling factor d of PZT-5A is given by the tensor

$$d = \begin{bmatrix} 0 & 0 & 0 & 0 & 584 & 0 \\ 0 & 0 & 0 & 584 & 0 & 0 \\ -171 & -171 & 374 & 0 & 0 & 0 \end{bmatrix} \cdot 10^{-12}\frac{C}{m}. \tag{5}$$

The feasibility of the approach according to embodiments of the present invention can be analyzed based on the lateral extension of the piezoelectric substrate. In order to extend the flexure length by 4.3 nm the substrate has to extend laterally by that value over a length of 2.5 mm (1 mm flexure length + 1.5 mm as half of the mass width). This relates to a strain inside the PZT material of 1.72 $10^{-6}$. This strain can be achieved by an electrical field of 10 kV/m. This field can be provided by a moderate voltage of 10 V applied over a PZT-thickness of 1 mm.

As an example, energy harvesting structures according to embodiments of the present invention can be made, with a footprint of around 1 $cm^2$. Such devices can have a frequency change of up to 5%, and an output power of about 100 μW.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to include any specific characteristics of the features or aspects of the invention with which that terminology is associated.

**Claims**

1. A microstructure (10, 20) comprising a substrate (11, 21), a resonant structure (12, 15; 22, 25) having a resonance frequency, comprising a seismic mass (12, 22) and suspension elements (13, 23) for suspending the seismic mass (12, 22) at two opposite sides onto the substrate (11, 21),
   wherein the substrate (11, 21) is adapted for functioning as a tuning actuator adapted for applying stress onto the suspension elements (13, 23), thus changing the stiffness of the suspension elements (13, 23).

2. A microstructure (10, 20) according to claim 1, wherein the substrate (11, 21) is made from piezoelectric material forming the tuning actuator.

3. A microstructure (10) according to claim 2, wherein the substrate (11) comprises piezoelectric bulk material with in-plane extension.

4. A microstructure (10) according to claim 3, the substrate (11) having a top and a bottom major surface, the microstructure (10) furthermore comprising a first electrode (16) at the top and a second electrode (17) at the at the bottom major surface of the substrate (11) for actuating the piezoelectric material.

5. A microstructure (20) according to claim 2, wherein the substrate comprises two piezoelectric shear actuators (21).

6. A microstructure (20) according to claim 5, wherein the microstructure (20) furthermore comprises interdigitated electrodes (27, 28) for actuating the piezoelectric material.

7. A microstructure (10, 20) according to any of the previous claims, wherein the suspension elements (13, 23) comprise a straight beam (15, 25) and an anchor point (14, 24), the straight beam (15, 25) being attached between the seismic mass (12, 22) and the anchor point (14, 24).

8. A microstructure (10, 20) according to claim 7, wherein the anchor point (14, 24) is mechanically attached to the substrate (11, 21).

9. A microstructure (10, 20) according to any of the previous claims, wherein the resonant structure (12, 15; 22, 25) is any of a MEMS or a NEMS structure.

10. A microstructure (10, 20) according to any of the previous claims, wherein the resonant structure (12, 15; 22, 25) is a double clamped structure.

11. Use of a microstructure according to any of claims 1 to 10 in any of a vibration energy harvester or a sensor.

12. A method for tuning a resonance frequency of a resonant structure (12, 15; 22, 25) being anchored to a substrate (11, 21) at two opposite sides by means of suspension elements (13, 23); the method comprising applying a stress on the suspension elements (13, 23) by means of the substrate (11, 21), thus changing the stiffness of the suspension elements (13,23).

13. A method according to claim 12, wherein applying a stress by means of the substrate (11, 21) includes actuating a piezoelectric substrate.

**14.** A method according to claim 13, wherein actuating a piezoelectric substrate comprises shear actuation of the piezoelectric substrate (21).

**15.** A method according to claim 13, wherein actuating a piezoelectric substrate comprises applying an electric field over a thickness of the piezoelectric substrate (11).

FIG. 1(a)

FIG. 1(b)

**20**

**23**

**23**

**24** **25**

**28**

**25** **24**

**26**

**21**

**22**

**21**

**29a**

**29a**

**24** **25**

**27**

**25** **24**

**V**

**V'**

**23**

**23**

**200**

**FIG. 2**

300

32    31    30    31    32

33    33

**FIG. 3**

21

27    40    28    26

**FIG. 4**

FIG. 5(a)

FIG. 5(b)

EUROPEAN SEARCH REPORT

Application Number

EP 09 17 1473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/144154 A1 (ASAI NOBUAKI [JP]) 19 June 2008 (2008-06-19) * paragraphs [0047] - [0063]; figures 2-5 * * paragraphs [0073] - [0077]; figure 6A * * paragraph [0039] * ----- | 1,7-9,12 | INV. H01L41/113 H03H9/02 B81B3/00 |
| X | JP 2008 111882 A (SEIKO EPSON CORP) 15 May 2008 (2008-05-15) * abstract; figure 1 * ----- | 1,7-8,12 | |
| A | EP 1 526 399 A1 (SAMSUNG ELECTRONICS CO LTD [KR]) 27 April 2005 (2005-04-27) * paragraphs [0014] - [0035]; figures 1-5 * ----- | 1 | |
| A | ADAMS S G ET AL: "Independent tuning of the linear and nonlinear stiffness coefficients of a micromechanical device" MICRO ELECTRO MECHANICAL SYSTEMS, 1996, MEMS '96, PROCEEDINGS. AN INVE STIGATION OF MICRO STRUCTURES, SENSORS, ACTUATORS, MACHINES AND SYSTEM S. IEEE, THE NINTH ANNUAL INTERNATIONAL WORKSHOP ON SAN DIEGO, CA, USA 11-15 FEB. 1996, NEW YORK, NY, USA,IE, 11 February 1996 (1996-02-11), pages 32-37, XP010159356 ISBN: 978-0-7803-2985-0 * the whole document * ----- -/-- | 1 | TECHNICAL FIELDS SEARCHED (IPC) H01L H03H B81B |

The present search report has been drawn up for all claims

| Place of search | Date of completion of the search | Examiner |
|---|---|---|
| Munich | 9 March 2010 | Steiner, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 09 17 1473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LEE K B ET AL: "A triangular electrostatic comb array for micromechanical resonant frequency tuning" SENSORS AND ACTUATORS A, ELSEVIER SEQUOIA S.A., LAUSANNE, CH, vol. 70, no. 1-2, 1 October 1998 (1998-10-01), pages 112-117, XP004140120 ISSN: 0924-4247 * the whole document * | 1 | |
| A | VINOD R CHALLA ET AL: "A vibration energy harvesting device with bidirectional resonance frequency tunability" SMART MATERIALS AND STRUCTURES, IOP PUBLISHING LTD., BRISTOL, GB, vol. 17, no. 1, 1 February 2008 (2008-02-01), page 15035, XP020130153 ISSN: 0964-1726 * the whole document * | 1 | |

TECHNICAL FIELDS
SEARCHED      (IPC)

The present search report has been drawn up for all claims

| Place of search | Date of completion of the search | Examiner |
|---|---|---|
| Munich | 9 March 2010 | Steiner, Markus |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 09 17 1473

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2010

| Patent document cited in search report | | Publication date | Patent family member(s) | | Publication date |
|---|---|---|---|---|---|
| US 2008144154 | A1 | 19-06-2008 | JP<br>WO | 2007025608 A<br>2007010981 A1 | 01-02-2007<br>25-01-2007 |
| JP 2008111882 | A | 15-05-2008 | NONE | | |
| EP 1526399 | A1 | 27-04-2005 | DE 602004008182 T2<br>JP 4012535 B2<br>JP 2005128551 A<br>KR 20050039232 A<br>US 2007236767 A1<br>US 2005088720 A1 | | 30-04-2008<br>21-11-2007<br>19-05-2005<br>29-04-2005<br>11-10-2007<br>28-04-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Resonance tuning of piezoelectric vibration energy scavenging generators using compressive axial preload. *Smart Materials and Structures,* 2006, vol. 15, 1413-1420
- A closed-form approach for frequency tunable comb resonators with curved finger contour. *Sensors and Actuators A,* 2008, vol. 141, 523-529
- **B. Morgan.** Vertically-shaped tunable MEMS resonators. *Journal of Microelectromechanical Systems,* 2008, vol. 17 (1), 85
- **D. Scheibner.** A frequency selective silicon vibration sensor with direct electrostatic stiffness modulation. *Analog integrated Circuits and Signal Processing,* 2003, vol. 37, 35-43